Europäisches Patentamt

European Patent Office

Office européen des brevets

(11) Publication number: **0 186 301**
**B1**

# EUROPEAN PATENT SPECIFICATION

(45) Date of publication of patent specification: **31.01.90**

(21) Application number: **85308371.5**

(22) Date of filing: **18.11.85**

(51) Int. Cl.⁵: **H 01 L 29/72, H 01 L 29/36**

(54) **High-speed semiconductor device.**

(30) Priority: **19.11.84 JP 242412/84**

(43) Date of publication of application:
**02.07.86 Bulletin 86/27**

(45) Publication of the grant of the patent:
**31.01.90 Bulletin 90/05**

(84) Designated Contracting States:
**DE FR GB**

(56) References cited:
**US-A-4 353 081**

**APPLIED PHYSICS LETTERS, vol. 43, no. 6, 15th
September 1983, pages 588-590, American
Institute of Physics, New York, US; T.C.L.G.
SOLLNER et al.: "Resonant tunneling through
quantum wells at frequencies up to 2.5 THz"**

**APPLIED PHYSICS LETTERS, vol. 24, no. 12, 15th
June 1974, pages 593-595, American Institute of
Physics, New York, US; L.L. CHANG et al.:
"Resonant tunneling in semiconductor double
barries"**

(73) Proprietor: **FUJITSU LIMITED
1015, Kamikodanaka Nakahara-ku
Kawasaki-shi Kanagawa 211 (JP)**

(72) Inventor: **Imamura, Kenichi
Honatsugi Sukaihaitsu 919 85-1, Nakaechi
Atsugi-shi Kanagawa 243 (JP)**
Inventor: **Yokoyama, Naoki
Rivahaitsu 326 2557-1, Tsumada
Atsugi-shi Kanagawa 243 (JP)**
Inventor: **Ohshima, Toshio
3-1-8-104, Tobio
Atsugi-shi Kanagawa 243-02 (JP)**

(74) Representative: **Billington, Lawrence Emlyn
et al
HASELTINE LAKE & CO Hazlitt House 28
Southampton Buildings Chancery Lane
London WC2A 1AT (GB)**

(56) References cited:
**APPLIED PHYSICS LETTERS, vol. 44, no. 1, 1st
January 1984, pages 105-106, American
Institute of Physics, New York, US; L.C. CHIU et
al.: "Graded collector heterojunction bipolar
transistor"**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to a high speed semiconductor device, for example that known as a hot electron transistor (HET).

Examples of related references in the field are as follows:

"Resonant Tunneling in Semiconductor Double Barriers", by L. L. Chang, L. Esaki, and R. Tsu, in Applied Physics Letters, Vol. 24, No. 12, 15 June 1974;

Japanese Unexamined Patent Publication (Kokai) No. 58-3277 published on January 10, 1983, Applicant: International Business Machines Corporation;

Inventor: L. Esaki, claiming priority based on United States Application Serial Number 280,141 filed on February 5, 1982;

"Characterization of Double Heterojunction GaAs/AlGaAs Hot Electron Transistors", N. Yokoyama, et al. Proceedings of the IEEE International Electron Devices Meeting, Dec. 1984, pp. 532 to 535; and

United States Application Serial No. 754,416, filed July 12, 1985 or European Patent Application No. 85401440.4, filed July 15, 1985.

In recent years, due in part to advances made in molecular beam epitaxy (MBE) technology, there have been proposed semiconductor devices using heterojunctions. Among the same, considerable expectations are placed on HET's as high speed semiconductor devices, since hot electrons are used in the HET's as carriers and thus the transit time of the hot electrons through the HET base is drastically shortened (United States Application Serial No. 722,053, filed April 11, 1985, or European Patent Application No. 85400744.0, filed April 16, 1985).

HET's proposed prior to the present invention, however, contain the problems of high power consumption and low switching speed, because the lowest collector-emitter voltage for conducting current through the HET is relatively high.

US—A—4,353,081 discloses an asymmetric potential barrier created by a sawtooth-shaped composition profiled of $Al_xGa_{1-x}As$ between layers of n-type GaAs. One disclosed use of such a potential barrier is in a HET having an emitter, base, and collector separated by barrier layers graded in opposite directions with the step of the profile in each case adjacent the base.

According to the present invention, there is provided a hot-electron-transistor type semiconductor device comprising:

an emitter layer, a base layer, and a collector layer, all of the same conductivity type;

an emitter potential barrier layer disposed between said emitter layer and said base layer; and

a collector potential barrier layer disposed between said base layer and said collector layer;

said collector potential barrier layer having a structure having a barrier height changing from a high level to a low level along the direction from said base layer to said collector layer when the device is in a thermal equilibrium state;

characterised in that said emitter potential barrier layer has a constant barrier height when the device is in thermal equilibrium and in that the high level of the barrier height of said collector potential barrier layer is lower than the kinetic energy of hot electrons which tunnel from said emitter layer through said emitter potential barrier layer to said base layer when a potential bias voltage is applied between said base layer and said emitter layer, even when a collector-emitter voltage is close to zero.

An embodiment of the present invention may improve the power consumption characteristic of an HET.

An embodiment of the present invention may improve the switching speed characteristic of an HET.

Reference is made, by way of example, to the accompanying drawings in which:

Fig. 1A is an energy band diagram of a thermal equilibrium state of a prototype HET prior to the present invention;

Fig. 1B is an energy band diagram of an operating state of a prototype HET prior to the present invention;

Fig. 1C is an energy band diagram showing a state when the collector-emitter voltage $V_{CE}$ is zero in a prototype HET prior to the present invention;

Fig. 2 is a graph illustrating a relationship between the collector-emitter voltage $V_{CE}$ and the collector current $I_C$ in an HET prior to the present invention;

Fig. 3 is a cross-sectional view of an HET according to an embodiment of the present invention;

Fig. 4A is an energy band diagram showing a thermal equilibrium state of an HET according to an embodiment of the present invention;

Fig. 4B is an energy band diagram in an operating state of the HET of Fig. 4A;

Fig. 5 is a graph diagram illustrating a relationship between the collector-emitter voltage $V_{CE}$ and the collector current $I_C$ in the HET of Fig. 4B;

Fig. 6A is an energy band diagram showing a thermal equilibrium state of an HET according to another embodiment of the present invention; and

Fig. 6B is an energy band diagram showing an operating state of the HET of Fig. 6A.

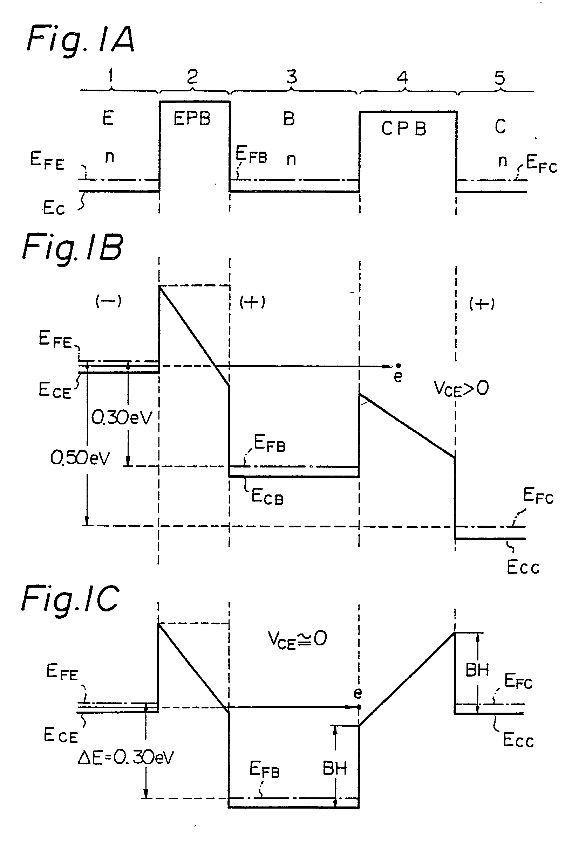

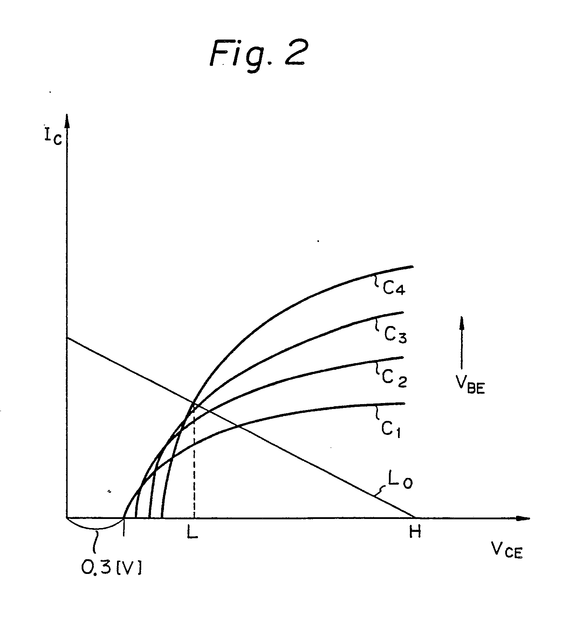

Before describing embodiments of the present invention, a prototype HET prior to the present invention and the problems therein will first be described with reference to Figs. 1A through 1C and Fig. 2.

Figs. 1A through 1C are energy band diagrams of a thermal equilibrium state, an operating state, and a state when $V_{CE}$ is zero, respectively, in a prototype HET prior to the present invention. The prototype HET has five layers, i.e., an n type GaAs emitter layer (E) 1, a non-

doped AlGaAs emitter potential barrier layer (EPB) 2, an n type GaAs base layer (B) 3, a non-doped AlGaAs collector side potential barrier layer (CPB) 4, and an n type GaAs collector layer (C) 5. In the Figs. 1A through 1C, the solid lines represent the lowest energy level $E_C$ of the conduction band in respective layers.

In the thermal equilibrium state, since no voltage is applied between the emitter layer 1 and the base layer 3 or between the emitter layer 1 and the collector layer 5, the Fermi levels $E_{FE}$, $E_{FB}$, and $E_{FC}$ in the emitter layer 1, in the base layer 3, and in the collector layer 5 are the same as each other, as shown in Fig. 1A.

In such an HET, a positive bias voltage $V_{CE}$ is applied between the collector layer 5 and the emitter layer 1, and a positive bias voltage $V_{BE}$ is applied between the base layer 3 and the emitter layer 1 so that the base Fermi level $E_{FV}$ is lowered by, for example, 0.30 eV, from the emitter Fermi level, and the collector Fermi level $E_{FC}$ is lowered by, for example, 0.50 eV, from the emitter Fermi level. The energy band diagram in this state is shown in Fig. 1B. Due to the positive bias voltages, the gradient of the energy level in the emitter potential barrier layer 2 or in the collector potential barrier layer 4 becomes larger. As a result of the larger gradient in the emitter potential barrier layer 2, the emitter barrier becomes thinner. Thus, electrons injected from the emitter layer 1 can tunnel through the emitter potential barrier 2 to be injected in the base layer 3. There, the potential energy held by the electrons *e* is converted to kinetic energy so that the electrons become high-speed hot electrons. Since the level of collector potential barrier layer 4 is also lowered and has a gradient due to the lowered energy levels of the base Fermi level $E_{FB}$ and the collector Fermi level $E_{FC}$, the hot electrons can pass through the collector potential barrier layer 4 to be injected into the collector layer 5 without scattering.

In prior HET's however, problems arise when the collector-emitter voltage $V_{CE}$ is close to zero, as shown in Fig. 1C. That is, since the emitter Fermi level $E_{FE}$ and the collector Fermi level $E_{FC}$ are equal in this case, and the collector potential barrier layer 4 has a height BH from the lowest level of the collector conduction band $E_{CC}$, the kinetic energy of the hot electrons in the base layer is lower than the barrier height BH from the collector conduction band $E_{CC}$. Therefore, the hot electrons cannot pass through the collector potential barrier 4. More specifically, if the collector potential barrier layer 4 is comprised of intrinsic-type $Al_{0.3}Ga_{0.7}As$, the barrier height BH there would be approximately 0.3 eV. Since the thickness of the emitter potential barrier layer 2 would be 250 to 500 Å (25 nm to 50 nm), and the thickness of the collector side potential barrier layer 4 would be 1500 to 2000 Å (150 nm to 200 nm), in the state where the collector emitter voltage $V_{CE}$ is close to zero, even if a base emitter voltage $V_{BE}$ were applied to give the level difference ΔE of 0.30 eV, the electrons would tunnel through the emitter potential barrier layer 2, but could not cross the collector potential barrier layer 4.

Fig. 2 is a graph showing the relationship between the collector emitter voltage $V_{CE}$ and the collector current $I_C$ in a prototype HET prior to the present invention.

In the Figure, the horizontal axis indicates the collector emitter voltage $V_{CE}$ and the vertical axis the collector current $I_C$. $C_1$ through $C_4$ are curves representing voltage-current characteristics. $L_0$ represent a load line.

As may be judged from the Figure, when the collector emitter voltage $V_{CE}=0$, no collector current $I_C$ flows. It only begins to flow when a voltage enabling overcoming of the barrier height BH=0.3 eV, i.e., a voltage of $V_{CE}=0.3$ V or more, is applied. Further, if the base emitter voltage $V_{BE}$ is raised, the collector emitter voltage $V_{CE}$ required for raising the collector current $I_C$ would shift (increase). Further, if the base emitter voltage $V_{BE}$ is raised, the electrons at the emitter layer 1 would tunnel through at a location close to the bottom of the conduction band. Therefore, to pass a collector current $I_C$ under such a state, the collector emitter voltage $V_{CE}$ would have to be further increased.

In general, in this type of semiconductor device, if the collector current $I_C$ can flow regardless of the impressed collector emitter voltage $V_{CE}$ being low, the switching speed can naturally be improved and the power consumption reduced.

In addition, when the prototype HET is used as a logic element in a logic circuit, the low output level L is too high as will be seen from the intersection of load line $L_0$ with one of the curves $C_1$ through $C_4$. Therefore, when the prototype HET is used as a logic element in a logic circuit, a level shift circuit to lower the low output level is needed.

The present invention enables a collector current $I_C$ to flow even when the collector emitter voltage $V_{CE}$ is almost zero.

In the high speed semiconductor device of the present invention, the value x at a nondoped $Al_xGa_{1-x}As$ collector potential barrier layer existing between the base layer and collector layer is gradually reduced from said base layer side to said collector layer side to provide a so-called grading state.

With the above-mentioned constitution, the barrier height BH at the collector potential barrier layer is gradually reduced from the base layer side to the collector layer side, so even when the collector emitter voltage $V_{CE}$ is close to almost zero, if the base emitter voltage $V_{BE}$ is applied, electrons tunneling from the emitter layer through the emitter side potential barrier layer for injection into the base layer will be able to cross the collector side potential barrier layer and reach the collector layer without hindrance.

Embodiments of the present invention will be described in the following.

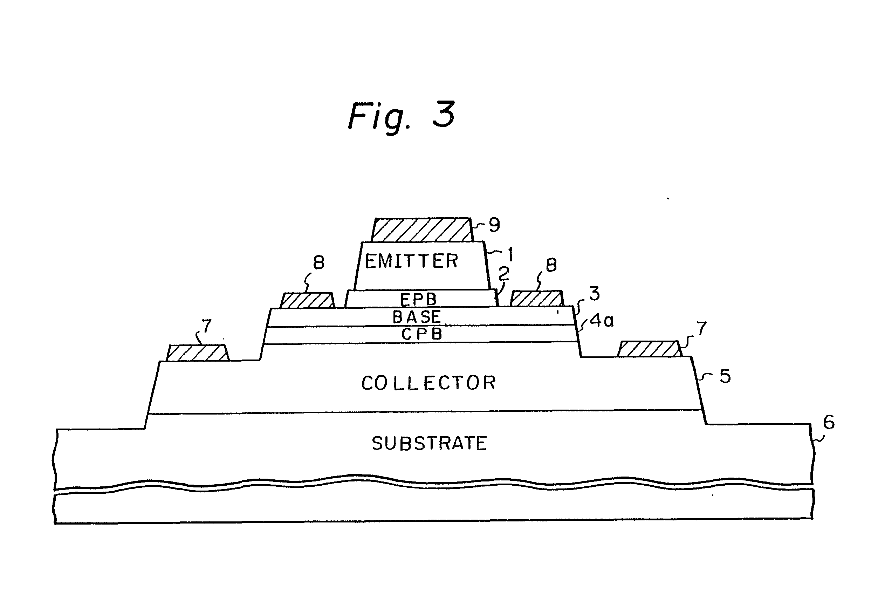

Fig. 3 is a cross-sectional view of an HET according to an embodiment of the present invention. In Fig. 3, reference numerals 1, 2, 3, and 5 represent an emitter layer, an emitter potential barrier layer, a base layer, and a collector layer, respectively. According to this embodiment of the present invention, a new collector potential barrier layer 4a is further provided.

The collector layer 5 is formed on a semiinsulating GaAs substrate 6, the collector-potential barrier (CPB) layer 4a is formed on the collector layer 5, the base layer 3 is formed on the CPB 4a, and the emitter-potential barrier (EPB) layer 2 is formed on the base layer 3. The emitter layer 1 is formed on the emitter-potential barrier layer 2, and a collector electrode 7 made of gold · germanium/gold (Au · Ge/Au) is formed on the collector layer 5 so as to be in ohmic contact with the collector layer 5. The notation Au · Ge/Au represents a state wherein an alloy Au · Ge is covered by a layer of Au. A base electrode 8 made of gold · germanium/gold (Au · Ge/Au) is formed on the base layer 3 so as to be in ohmic contact with the base layer 3. The term Au · Ge/Au represents a state wherein an alloy Au · Ge is covered by a layer of Au. An emitter electrode 9 made of gold · germanium/gold (Au · Ge/Au) is formed on the emitter layer 1 so as to be in ohmic contact with the emitter layer 1.

Examples of the combination of the material in the embodiment shown in Fig. 3 are as follows.

Example 1
    Emitter layer 1: GaAs.
    Emitter potential barrier layer 2: $Al_yGa_{1-y}As$, where y is a constant, e.g., 0.3.
    Base layer 3: GaAs.
    Collector potential barrier layer 4a: $Al_xGa_{1-x}As$, where x is variable.
    Collector layer: GaAs.

Example 2
    Emitter layer 1: GaAs.
    Emitter potential barrier layer 2: $Al_yIn_{1-y}As$, where y is a constant, e.g., 0.47.
    Base layer 3: $In_zGa_{1-z}As$, where z is a constant, e.g., 0.53.
    Collector potential barrier layer 4a: $Al_xIn_{1-x}As$, where x is variable.
    Collector layer 5: GaAs.

In this example, the value x should be smaller than the value y.

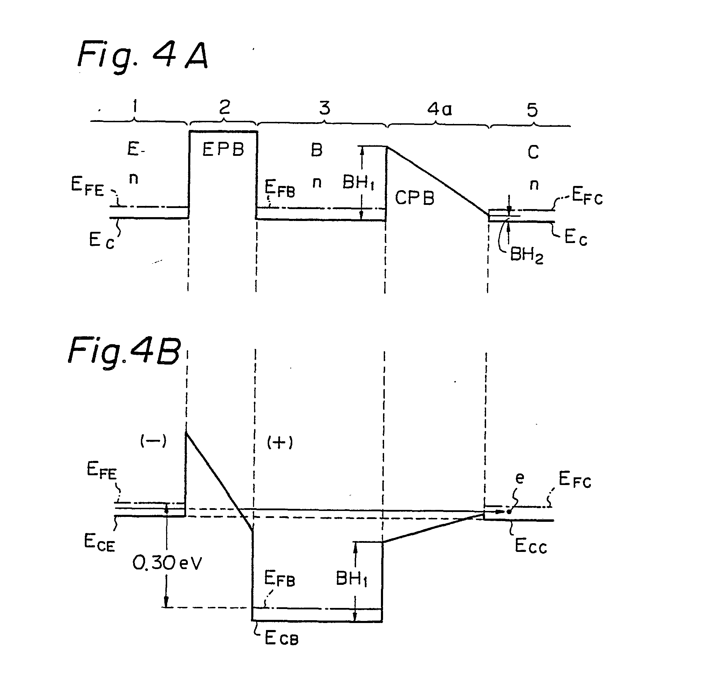

Fig. 4A is an energy band diagram in a thermal equilibrium state of the HET of the embodiment shown in Fig. 3. As will be seen from the comparison of Figs. 1A and 4A, the conduction band in the collector-potential barrier layer 4a in this embodiment has a structure having a barrier height changing from a high level to a low level along the direction from the base layer 3 to the collector layer 5. That is, the barrier height between the base layer 3 and the collector potential barrier layer 4a is $BH_1$, which is as high as, for example, 0.30 eV. The barrier height $BH_1$ may or may not be the same as the barrier height of the emitter potential barrier layer 2. In Fig. 4A, the barrier height $BH_1$ is shown as being lower than the barrier height of the emitter potential barrier layer 2. On the contrary, the barrier height between the collector potential barrier layer 4a and the collector layer 5 is $BH_2$, which is a value smaller than the potential barrier of the emitter potential barrier layer 2 and higher than the lowest energy level $E_{CC}$ of the conduction band in the collector layer 5. The potential barrier in the layer 4a is for example linearly decreased from $BH_1$ to $BH_2$.

In the Figure, the value x at the intrinsic type $Al_xGa_{1-x}As$ collector potential barrier layer 4a is reduced from the base layer 3 side to the collector layer 5 side, whereby a grading state is achieved. By doing so, the potential barrier also falls, as illustrated.

Fig. 4B is an energy band diagram illustrating in an operating state of the HET according to an embodiment of the present invention. In Fig. 4B, a positive bias voltage $V_{BE}$ is applied between the base layer 3 and the emitter layer 1 so that the base Fermi level $E_{FB}$ is lowered by, for example, 0.30 eV, from the emitter Fermi level $E_{FE}$. The lowest energy level $E_{CB}$ of the base conduction band is also lowered by 0.3 eV from the energy level $E_{CE}$. In this embodiment, no voltage is applied between the collector layer 5 and the emitter layer 1. Therefore, the lowest energy level $E_{CE}$ of the conduction band of the emitter layer 1 is the same as the lowest energy level $E_{CE}$ of the conduction band of the collector layer 5. Accordingly, the collector potential barrier layer 4a is lowered to be lower than the lowest energy level $E_{CC}$ of the collector conduction band. Each of the electrons e tunneling from the emitter layer 1 through the emitter potential barrier layer 2 to the base layer 3 has a kinetic energy higher than the energy level $E_{CE}$ or $E_{CC}$. Since the collector potential barrier layer 4a does not act as a potential barrier for the electrons having the energy higher than $E_{CC}$ or $E_{CE}$, the hot electrons in the base layer 3 will easily cross the collector potential barrier layer 4 and reach the collector layer 5.

The collector potential barrier layer 4a in Fig. 4B does not act as a potential barrier but acts as a PN junction, such as that in a conventional bipolar transistor, for insulating the base layer 3 from the collector layer 5.

The barrier height $BH_2$ at the collector layer 5 side is determined to be as small as possible as long as electrons in the collector layer 5 do not enter the base layer 3 due to thermal diffusion.

If for example the value x at the intrinsic type $Al_xGa_{1-x}As$ collector potential barrier layer 4a is made 0.3 at the base layer 3 side and 0.1 to 0.2 at the collector layer 5 side, the barrier height $BH_1$ of the base layer 3 side at the collector side potential barrier layer 4a may be 0.3 eV and the barrier height $BH_2$ of the collector layer 5 side may be 0.1 to 0.2 eV.

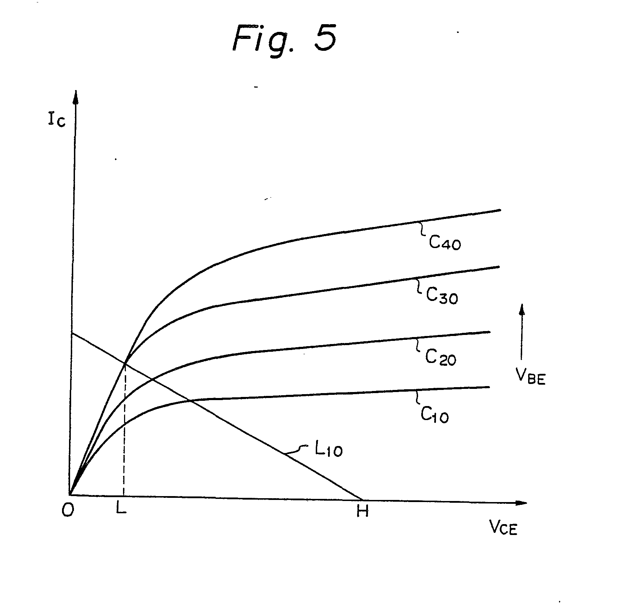

Fig. 5 is a graph showing the relationship between the collector emitter voltage $V_{CE}$ and the collector current $I_C$ according to an embodiment of the present invention in the state as shown in Fig. 4B.

In the Figure, the horizontal axis indicates the collector emitter voltage $V_{CE}$ and the vertical axis the collector current $I_C$.

As can be understood from the Figure, a collector current $I_C$ begins to flow even when the collector emitter voltage $V_{CE}$ is almost zero. Further, even if the base emitter voltage $V_{BE}$ is made high, there is almost no shifting of the lowest collector emitter voltage $V_{CE}$ for conducting a collector current $I_C$. Therefore, the switching speed can be improved and the power consumption reduced.

Further, the low output L shown in Fig. 5 is sufficiently low in comparison with the low output shown in Fig. 2. Therefore, the HET according to the embodiment of the present invention is convenient for use in a logic circuit, since no level shift circuit is necessary.

To change the structure of the intrinsic type $Al_xGa_{1-x}As$ collector side potential barrier layer as in the present invention, the content of Al in the crystalline layer may be gradually changed or the MBE method may be applied to form superimposed films of intrinsic type $Al_xGa_{1-x}As$ with different x values.

Further, when reducing the barrier height from the base layer side to the collector layer side as mentioned above, there might be thought to be some cause for concern with the withstand (breakdown) voltage between the collector and base. The withstand voltage when the collector layer is made positive in potential, should be more than the power supply voltage at the circuit. When made negative in potential, however, it may be about the same as the withstand voltage between the base and emitter. Therefore, the problem of withstand voltage is not an immediate concern.

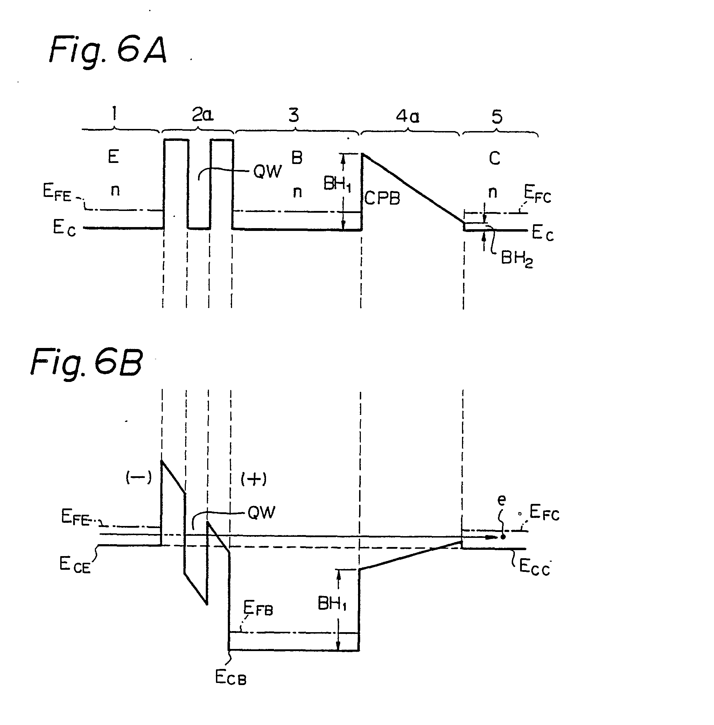

Fig. 6A and 6B show another embodiment of the present invention. As shown in Fig. 6A, another (alternative) emitter potential barrier layer 2a is employed in this embodiment. The emitter potential barrier layer 2a has at least one quantum well QW known as a superlattice. The quantum well QW is made of, for example, GaAs. Both emitter barrier layers $2a_1$ and $2a_2$ adjacent to the quantum well QW are made of $Al_xGa_{1-x}As$, where x is a value equal to 0.33. The value x in the layers $2a_1$ and $2a_2$ should be greater than a value y in $Al_yG_{1-y}As$ in the collector potential barrier layer 4a.

Resonant tunneling through such a quantum well QW itself is a known phenomenon, described in, for example, "Resonant tunneling through quantum wells at frequencies up to 2.5 THz", by T. C. L. G. Sollner, et al., Appl. Phys. Lett. 43 (6), 15 September 1983 pp. 588—590.

By employing a quantum-well structure, or superlattice, the so-called resonant tunneling is carried out near the Fermi level. Therefore, the tunneling effect through the emitter potential barrier layer 2a is carried out more effectively in comparison with the first embodiment shown in Fig. 4A. A resonant hot electron transistor (RHET) has already been proposed, (see United States Application Serial No. 754,416, or European Patent Application No. 85401440.4).

In the embodiment shown in Figs. 6A and 6B, the superlattice structure is applied to the emitter potential barrier layer 2a. The operation of a resonant hot electron transistor employing the graded collector potential barrier layer 4a is very similar to the operation as described with reference to Fig. 4B. Therefore, the description for operation with reference to Fig. 6B is omitted here.

With the above-mentioned constitution, the barrier height at the collector potential barrier layer is gradually reduced from the base layer side to the collector layer side, so even when almost no collector emitter voltage is applied, electrons tunneling from the emitter layer through the emitter potential barrier for injection into the base layer will be able to cross the collector side potential barrier layer and reach the collector layer without any hindrance.

Therefore, even when the collector emitter voltage is almost zero, a collector current may flow immediately upon application of the base emitter voltage. As a result, the switching speed can be improved and the power consumption reduced.

## Claims

1. A hot-electron-transistor type semiconductor device comprising:
   an emitter layer, a base layer, and a collector layer, all of the same conductivity type;
   an emitter potential barrier layer disposed between said emitter layer and said base layer; and
   a collector potential barrier layer disposed between said base layer and said collector layer;
   said collector potential barrier layer having a structure having a barrier height changing from a high level to a low level along the direction from said base layer to said collector layer when the device is in a thermal equilibrium state;
   characterised in that said emitter potential barrier layer has a constant barrier height when the device is in thermal equilibrium and in that the high level of the barrier height of said collector potential barrier layer is lower than the kinetic energy of hot electrons which tunnel from said emitter layer through said emitter potential barrier layer to said base layer when a potential bias voltage is applied between said base layer and said emitter layer, even when a collector-emitter voltage is close to zero.

2. A semiconductor device as set forth in claim 1, wherein said collector potential barrier layer is formed by non-doped $Al_xGa_{1-x}As$, where the value x gradually decreases from said base layer side to said collector layer side.

3. A semiconductor device as set forth in claim 1, wherein said collector potential barrier layer is formed by non-doped $Al_xIn_{1-x}As$, where x gradually decreases from said base layer side to said collector layer side.

4. A semiconductor device as set forth in claim 1, 2 or 3, wherein said emitter potential barrier layer has additionally at least one quantum well, whereby the passage of electrons from said emitter layer to said base layer may be effected by resonant tunneling.

ten Basisschicht durch resonantes Tunneln beeinflußt werden kann.

**Patentansprüche**

1. Halbleitervorrichtung vom Typ eines Transistors mit heißen Elektronen, mit:
   einer Emitterschicht, einer Basisschicht, und einer Kollektorschicht, die alle vom selben Leitfähigkeitstyp sind;
   einer Emitterpotentialsperrschicht, die zwischen der genannten Emitterschicht und der genannten Basisschicht angeordnet ist; und
   einer Kollektorpotentialsperrschicht, die zwischen der genannten Basischicht und der genannten Kollektorschicht angeordnet ist;
   bei welcher die genannte Kollektorpotentialsperrschicht eine Struktur hat, die eine Sperrschichthöhe hat, welche längs der Richtung von der genannten Basisschicht zu der genannten Kollektorschicht sich von einem hohen Pegel zu einem niedrigen Pegel ändert, wenn die Vorrichtung in einem thermischen Gleichgewichtszustand ist;
   dadurch gekennzeichnet, daß die genannten Emitterpotentialsperrschicht eine konstante Sperrschichthöhe hat, wenn die Vorrichtung sich in einem thermischen Gleichgewicht befindet, und der hohe Pegel der Sperrschichtthöhe der genannten Kollektorpotentialsperrschicht niedriger als die kinetische Energie der heißen Elektronen ist, welche von der genannten Emitterschicht durch die genannte Emitterpotentialsperrschicht zu der genannten Basisschicht tunneln, wenn eine Potentialvorspannung zwischen die genannte Basisschicht und die genannte Emitterschicht aufgebracht wird, selbst wenn eine Kollektor-Emitter-Spannung nahe bei 0 ist.

2. Halbleitervorrichtung nach Anspruch 1, bei der die genannte Kollektorpotentialsperrschicht durch nicht dotiertes $Al_xGa_{1-x}As$ gebildet ist, wobei der Wert x graduierlich von der genannten Basisschichtseite zu der genannten Kollektorschichtseite abfällt.

3. Halbleitervorrichtung nach Anspruch 1, bei der die genannte Kollektorpotentialsperrschicht durch nicht dotiertes $Al_xIn_{1-x}As$ gebildet ist, wobei x graduierlich von der genannten Basisschichtseite zu der genannten Kollektorschichtseite abfällt.

4. Halbleitervorrichtung nach Anspruch 1, 2 oder 3, bei der die genannte Emitterpotentialsperrschicht zusätzlich wenigstens einen Quantentopf hat, wodurch die Passage der Elektronen von der genannten Emitterschicht zu der genann-

**Revendications**

1. Dispositif semiconducteur du type transistor à électrons chauds comprenant:
   une couche d'émetter, une couche de base et une couche de collecteur ayant toutes le même type de conductivité;
   une couche de barrière de potentiel d'émetteur disposée entre ladite couche d'émetteur et ladite couche de base; et
   une couche de barrière de potential de collecteur disposée entre ladite couche de base et ladite couche de collecteur;
   ladite couche de barrière de potentiel de collecteur ayant une structure dans laquelle la hauteur de barrière varie d'un niveau haut vers un niveau bas suivant la direction qui va de ladite couche de base à ladite couche de collecteur lorsque le dispositif est un équilibre thermique;
   caractérisé en ce que ladite couche de barrière de potentiel d'émetteur possède une hauteur de barrière constante lorsque le dispositif est en équilibre thermique et en ce que le niveau haut de la hauteur de barrière de ladite couche de barrière de potentiel de collecteur est inférieur à l'énergie cinétique des électrons chauds qui traversent par effet tunnel la couche de barrière de potentiel d'émetteur, de ladite couche d'émetteur vers ladite couche de base, lorsqu'une tension de polarisation de potentiel est appliquée entre ladite couche de base et ladite couche d'émetteur, même lorsque la tension collecteur-émetteur est proche de zéro.

2. Dispositif semiconducteur selon la revendication 1, où ladite couche de barrière de potentiel de collecteur est formée par du $Al_xGa_{1-x}As$ non dopé, dans lequel la valeur x diminue graduellement du côté de ladite couche de base vers le côté de ladite couche de collecteur.

3. Dispositif semiconducteur selon la revendication 1, où ladite couche de barrière de potentiel de collecteur est formée par du $Al_xIn_{1-x}As$ non dopé, dans lequel la valeur x diminue graduellement du côté de ladite couche de base vers le côté de ladite couche de collecteur.

4. Dispositif semiconducteur selon la revendication 1, 2 ou 3, où ladite couche de barrière de potentiel d'émetteur possède en outre au moins un puits quantique, de sorte que le passage d'électrons de ladite couche d'émetteur jusquà ladite couche de base peut s'effectuer par effet tunnel résonnant.

*Fig. 1A*

*Fig. 1B*

*Fig. 1C*

## Fig. 2

## Fig. 3

EP 0 186 301 B1

*Fig. 4 A*

*Fig. 4B*

# Fig. 5

## Fig. 6A

## Fig. 6B